# EUROPEAN PATENT SPECIFICATION

(11) **EP 1 750 493 B1**
(45) Date of publication and mention of the grant of the patent: **16.03.2011**
(21) Application number: 05015346.9
(22) Date of filing: 14.07.2005
(51) Int. Cl.: H05K 7/20, H05K 5/02, B01D 39/00, B01D 39/08, B01D 39/16, B01D 39/18

(54) **Fan cooling unit for cooling electronic components**
Kühllüftereinheit zum Kühlen von elektronischen Bauelementen
Unité de refroidissement pour refroidir des composants électroniques

(43) Date of publication of application: 07.02.2007
(73) Proprietor: W.L.GORE & ASSOCIATES GMBH, 85640 Putzbrunn (DE)
(72) Inventor: Schwarz, Robert, 82194 Gröbenzell (DE); Rudolf, Christine, 85435 Erding (DE); POON Wai Sing, Hockessin DE 19707 (US); MULLER Jason W., Lincoln University PA 19357 (US)
(74) Representative: Klunker . Schmitt-Nilson . Hirsch

(56) References cited:
- DE-A1- 19 833 247
- US-A- 5 397 632
- US-A- 5 401 446
- US-A- 5 507 847
- US-A- 5 814 405
- US-A1- 2002 083 837
- US-A1- 2005 108 996

## Description

### BACKGROUND

The present invention relates to a fan cooling unit for cooling electronic components, in particular for use in locations exposed to the weather, such as in air-cooled telecommunications base stations.

A prior art fan cooling unit for an air-cooled telecommunications base station is described in WO 00/04980. It comprises a casing to take the electronic telecommunications components, at least one air inlet opening and at least one air outlet opening in the casing, at least one fan to produce a flow of air from the air inlet opening through the casing to the air outlet opening, and at least one protective covering to entirely cover at least the air inlet opening so as to remove particles from the air stream entering the casing. The protective covering comprises a composite filter media and a frame in which the composite filter media is mounted so as to create an air tight fit between the filter media and the frame. The filter media comprises a membrane filtration layer comprising a porous polymeric membrane and a supporting material on both the front face and the rear face of the membrane filtration layer, such as a non-woven web, woven fabric, knitted fabric, mesh or a perforated sheet. The supporting material and the membrane filtration layer may lie detached on top of one another or may form a laminate. The membrane filtration layer may be comprised of a synthetic polymer selected from the group polyethylene, polypropylene and fluoropolymers including tetrafluoroethylene/(perfluoroalkyl)vinyl ethyl copolymer (PFA), tetrafluoroethylene/hexafluoropropylenecopolymer (FEP) and polytetrafluoroethylene (PTFE), preferably expanded polytetrafluoroethylene (ePTFE). A louvered panel may be fit on the outside in front of the protective covering for protection against vandalism and mechanical damage but also prevents splash water from directly reaching the composite filter media.

The prior art fan cooling unit is particularly useful where the casing with the electronic components is located in the open air, with little or no protection and exposed to the weather conditions. The membrane filter media admits a high air stream, allowing to achieve a temperature difference of less than 10K by the fan cooling unit even at elevated ambient temperature and also guarantees protection against water and moisture penetration according to the high European Telecommunications Standards.

US 2005/0108996 A1 discloses a fan cooling unit for electronic components of similar structure, in which the respective filter media is realized as a filter system having two separate elements, an upstream filter element for filtering particulate matter and a downstream filter element of PTFE for filtering water vapor.

The object of the present invention is to propose a fan cooling unit with improved capabilities of the retention of water, moisture and any other elements that are contained in an air stream and that might lead to the deterioration or destruction of electronic components.

### SUMMARY OF THE INVENTION

This is achieved according to the invention by the fan cooling unit according to the aforementioned prior art, however with a different composite filter media of the protective covering. The composite filter media in the present invention comprises in addition to a membrane filtration layer at least one depth filtration media layer disposed on an upstream side of the membrane filtration layer relative to a direction of gas flow through the filter.

The depth filtration media layer preferably comprises fibers having an electrostatic charge, which charge is not so strong as to affect the electronic components in the casing. While electrically charged filter material may be made by a variety of known techniques, one convenient way of cold charging the fiber web is described in US 5,401,446. The charged fibers enhance filter performance by attracting small particles to the fibers and retaining them. It has been found that the pressure drop in the filter media thereby increases at a slower rate than it does without the electrical charge in the depth filtration media.

The removal of small particles within the depth filtration media (prefilter) prevents early clogging of the membrane filtration layer due to buildup of a filter cake on the membrane surface (which is a "surface" filtration media as compared to the "depth" filtration media). The permeability of the filter cake is therefore maintained over a longer period of time. It is estimated that the filter according to the present invention can be designed for continuous use in highly polluted areas for the lifetime of the electronic components without the need of filter replacement.

A support layer different from the depth filtration media is preferably provided on the upstream or downstream side of the membrane, to provide the support to withstand the air flow and the resulting pressure drop. It is to be noted, however, that the support layer will substantially affect the overall permeability of the filter media. This is in particular the preferred case where the support layer is laminated to the membrane. Conclusively, the permeability of the filter might be reduced by a factor of 5 due to the lamination with the support layer.

While the depth filtration media layer or layers preferably comprise a non-woven fibrous web, in particular a melt blown web, the membrane filtration layer is preferably made of porous polytetrafluoroethylene (ePTFE). ePTFE is hydrophobic and the fine microporous structure results in a surface that is resistant to water entry and highly efficient in capturing small particles; therefore it also effectively prevents salt particles from passing through. It has been proven particularly advantageous to use ePTFE membranes as described in US 5,814,405. The membranes described therein have high filtration efficiency, air flow and burst strength. Methods of making suitable ePTFE membranes are fully described therein and are incorporated herein by reference. These ePTFE membranes are available from W.L. Gore & Associates, Inc. of Newark, Delaware. However, ePTFE membranes of the same structure manufactured by other means can also be used.

It has been found that this particular kind of ePTFE membrane provides a good trade-off between the relevant factors: air permeability, water and salt retention, particle filtration efficiency and handling. In particular, pin holes which typically occur when the filter media is folded to form a pleated cartridge or panel filter appear to be no longer a problem when such ePTFE membranes are used.

These advantageous properties of the membrane can be attributed to their microstructure. More specifically, the ePTFE membranes described in US 5,814,405 have an internal microstructure consisting essentially of a series of nodes interconnected by fibrils, wherein the nodes are generally arranged in parallel, highly elongated and have an aspect ratio of 25:1 or greater, preferably 150:1 or greater. This can be achieved when the ePTFE membranes are formed from a blend of a PTFE homopolymer and a modified PTFE polymer.

While the mean flow pore sizes of the membranes disclosed in US 5,814,405 are in the range below or equal to 1.5 µm, it is preferred for the purposes of the present invention to have a mean flow pore size greater than 1.5 µm, in particular between 1.5 µm and 15 µm, and in a preferred embodiment about 3 µm. This can be easily achieved by further expanding the membrane during its manufacture in the longitudinal and/or transverse direction until the desired porosity is obtained.

It is thus possible to provide a protective covering comprising a composite filter media with a pleated laminate comprising an ePTFE membrane and a support layer and at least one electrostatically charged melt blown filter media, the laminate having an air permeability of about 3 Frazier to about 15 Frazier and a particle filtration efficiency of at least 90 % for 0.3 µm sized particle at 5.3 cm/s, whereas the melt blown filter media has an air permeability of about 30 Frazier to about 130 Frazier and a particle filtration efficiency of at least 50 % for 0.3 µm sized particles. Filtration efficiency of 99 % and higher for 0.3 µm particles could be obtained from such composite filter (H12-13), which is highly desirable for an air-cooled telecommunications base station.

With the present invention, a separate demister is not required. Also, the filter media of the present invention can be used in environments between -40°C and +70°C. Finally, a separate salt filter is not necessary because the membrane media is water resistant (IP X5) and also provides high salt retention. Corrosion of electronic components is thus effectively prevented. The single stage filter media according to the invention is light-weight, and estimate to have a long lifetime under severest environmental conditions.

Due to the multilayer structure of the composite filter media, only some very small air particles will penetrate the depth filtration media prefilter and will reach the membrane surface with a certain delay. The melt blown prefilter with a filtration efficiency of about 90%, thus, already filters a major part of the particles. Over the time a filter cake builds up on the upstream side of the prefilter. Such filter cake provides an additional filtering effect. The filter cake's filtering efficiency enhances over the time and constitutes a kind of pre-prefilter. When a filter loaded in the aforementioned manner is exposed to a humid climate with e. g. more than 90% relative humidity, the filter cake exhibits an important function for the entire filter media. More particularly, if the filter cake was built up directly on the surface of the membrane material, swelling of the filter cake particles in humid climate would result in an increased pressure drop over the filter media. However, such pressure drop increase is less if the filter cake is separated from the membrane surface such as by means of the prefilter.

### BRIEF DESCRIPTION OF THE DRAWINGS

FIG. 1 is a fan cooling unit according to the invention,
FIG. 2 is a perspective view of a protective cover for use in a fan cooling unit,
FIG. 3 is an annular protective covering,
FIG. 4 is a perspective view of a protective cover similar to the one shown in Fig. 2, however, with a louvred panel on the upstream side,
FIG. 5 is a cross-section through part of the protective covering in Fig. 2,
FIG. 6 is a cross sectional view of a composite filter media for the protective covering of the fan cooling unit of the present invention,
FIG. 7 is a cross sectional view of another composite filter media with a separate support layer on the downstream side of the filter media,
FIG. 8 is a cross sectional view of still another filter media with the separate support layer being centrally disposed,
FIG. 9 is a cross sectional view of a further filter media with an additional stabilizing layer on the upstream side of the filter media,
FIG. 10 depicts, as an example, an enlarged cross sectional view of the structure of a preferred membrane filtration layer forming part of the composite filter media, and
FIG. 11 is a graph showing the improved performance of the composite filter media over other membrane filters.

### DETAILED DESCRIPTION OF THE DRAWINGS

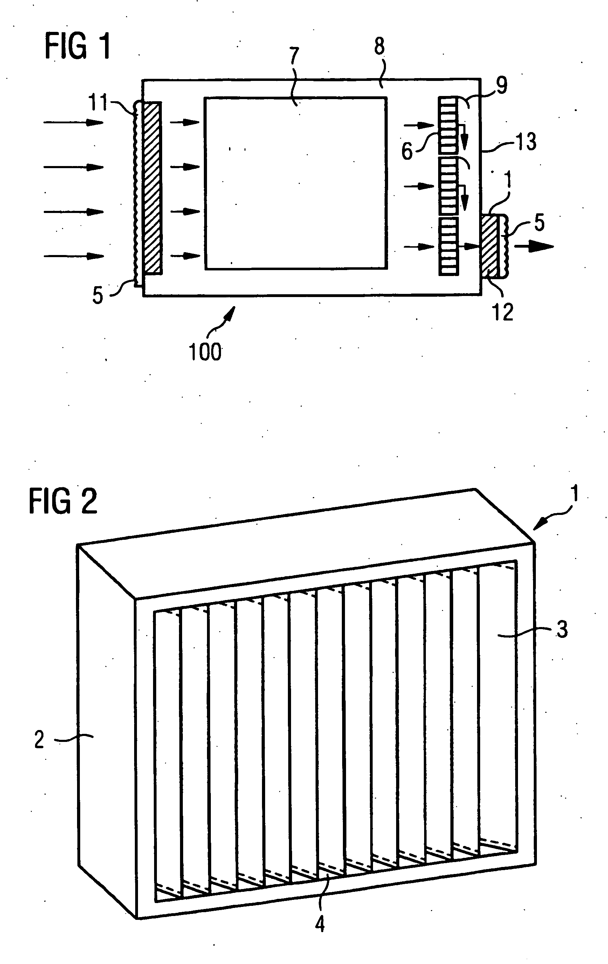

Fig. 1 shows diagrammatically a fan cooling unit 100 in which are arranged electronic components such as e. g. circuits, amplifiers, semi-conductors etc. which are referred to as a whole as 7. By means of one or more fans 6 arranged on a rear wall 13 of casing 8 is generated an air flow, the flow direction of which is indicated by arrows. The number of fans depends on the size of casing 8 and components 7 to be cooled. Suitable fans 6 are axial and radial fans. The air flow passes through an air inlet opening 11 into casing 8 and emerges from casing 8 on the opposite side through an air outlet opening 12. The air inlet and outlet openings 11,12 are sealed with a protective covering 1, where the protective covering is a water-tight porous material, so that the air drawn by the fan 6 can enter the casing interior exclusively through protective covering 1 and hence filter through filter media 3. The protective covering 1 can be arranged optionally inside or outside the casing 8 as shown diagrammatically in Fig. 1. A plate 5 in the form of a louvred panel is provided on the outside in front of protective covering 1 to protect against mechanical damage, vandalism and splash water. The air is drawn in preferably over the entire front face of casing 8, passed between the electronic components 7 and guided behind fans 6 by means of deflector plates 9 to air outlet opening 12. The deflector plates 9 help connect the air flow into the corners and guide the hot air to air outlet opening 12. A typical size of a casing 8 of a base station or switch cabinet of telecommunications devices erected in the open is 1500 x 1000 x 1000 mm³ (HxWxD) whereas the protective covering 1 for example has a size of 1000 x 450 x 100 mm³ (HxWxD). The dimensions depend on the size of the casing 8 and the air quantity to be transported.

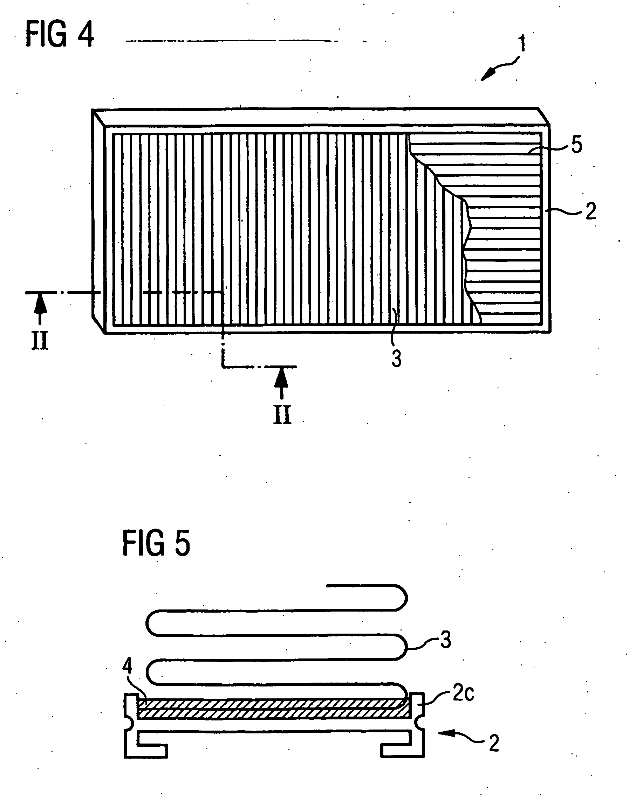

Fig. 2 to 5 show particular arrangements of the protective covering 1. Fig. 5 shows a frame 2 which can be made of plastic or metal, where for stability and weight reasons aluminum is preferred. In frame 2 is arranged filter media 3 folded in pleated form. The pleats are arranged vertically so as to allow moisture collected on the filter media front surface to flow down. As Fig. 2 shows, the depth of frame 2 is selected so that the two long side edges of folded filter media 3 do not project beyond a wall 2c of frame 2 so that an air tight connection can be created between filter media 3 and frame 2 in order to prevent air passing by filter media 3.

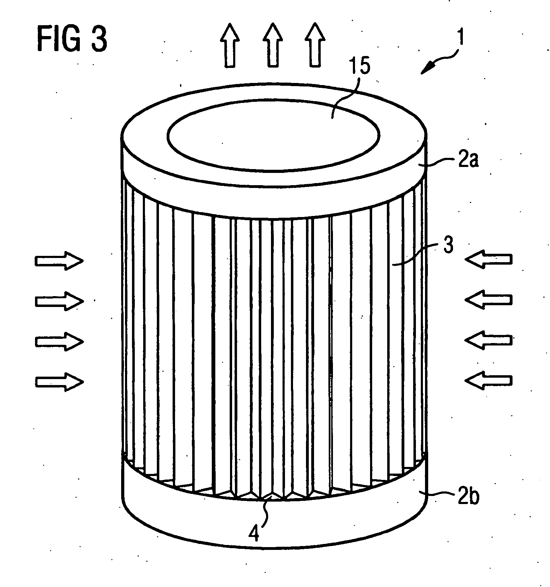

Filter media 3 is preferably folded upon itself in the pleated fashion shown in Fig. 2 so as to provide better structural integrity and to significantly increase the exposed surface area for filtration. The pleats may have a height of preferably not more than 250 mm, most preferably in the range of about 30 to 90 mm. While filter media 3 is shown in Fig. 2 as being pleated to form a pleated panel, it could be desirable to join the two edges of the panel to form a cylindrical filter media, as shown in Fig. 3. In this case, filter media 3 is arranged in a circle and its side edges are closed by corresponding closing caps 2a, 2b. The construction of such a cover where frame 2 is formed by two closing caps 2a, 2b essentially corresponds to a ring filter in cartridge form. A closing cap 2a has an opening 15 to allow air transport in the direction of the arrows. Closing cap 2a with opening 15 is connected to casing 8.

The pleats of pleated filter media 3 are preferably stabilized by spacers on the upstream and/or downstream side so as to allow filter operation at high face velocities of up to and over 5 cm/s.

Ideally, filter media 3 is mounted to frame 2 using a potting material 4 (Fig. 5), such as polyurethane, epoxy, silicone, hot-melt adhesive, or plastisol. In order to establish a tight seal, potting material 4 should be chosen or treated to wet-out into filter media 3 so as to assure a continuous seal. In one panel example, filter media 3 can be designed for an air flow capacity of up to 1500 m³/h, preferably about 200 m³/h to 500 m³/h.

Fig. 4 shows a protective covering 1 similar to the one in Fig. 2, however, with the louvred panel 5 integrally formed on its upstream side. The louvred panel 5 can be sealed in place along with filter media 3 by means of the potting material 4.

Composite filter media 3 used in protective covering 1 of fan cooling unit 100 of the present invention provides at least two filtration layers: a membrane filtration layer and a depth filtration layer. The membrane filtration layer comprises a porous polymeric membrane. Positioned upstream of the membrane filtration layer relative to the direction of air flow is at least one depth filtration media layer. Optionally, the composite filter media may include a support layer. The support layer may be positioned either upstream or downstream of the membrane filtration layer relative to the air flow through the filter. Optionally, the support layer may be laminated to the membrane.

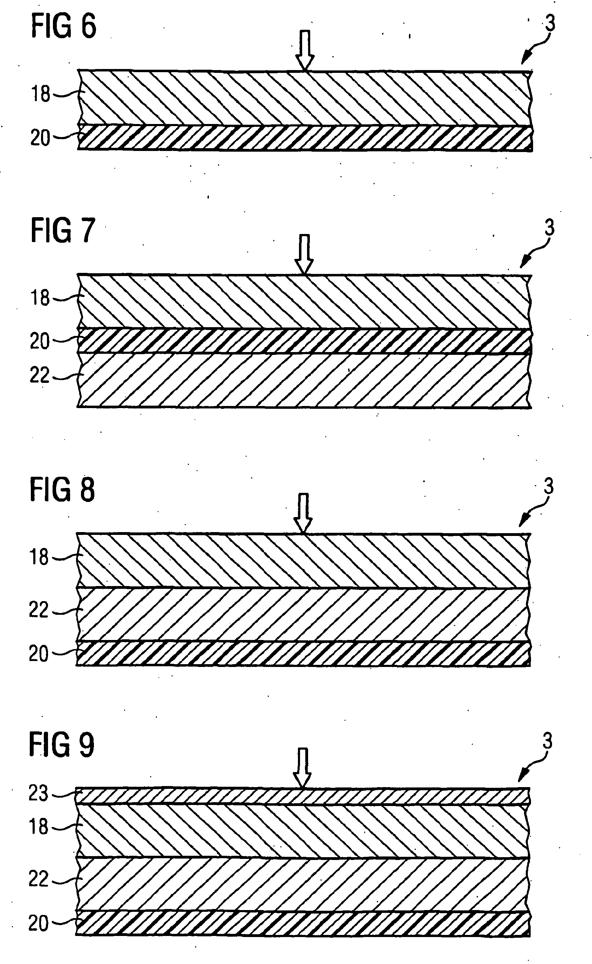

Figures 6 to 8 show cross-sections of several aspects of composite filter media 3. A depth filtration media layer 18 is positioned upstream of a membrane filtration layer 20, the direction of flow being indicated by an arrow (Fig. 6). Shown in Fig. 7 is a filtration media 3 comprising a support layer 22 disposed on the downstream side of membrane filtration layer 20. In Fig. 8, support layer 22 is disposed on the upstream side of membrane filtration layer 20 between depth filtration media layer 18 and membrane filtration layer 20. While support layer 22 is preferably laminated to membrane filtration layer 20, the depth filtration media layer 18 may be in loose contact with membrane filtration layer 20 and support layer 22, respectively.

In addition, as shown in Fig. 9, a stabilizing layer 23 in the form of e. g. a fibrous net can be arranged as an uppermost layer on top of depth filtration media layer 18 in order to prevent disarrangement of the fibers in depth filtration media layer 18 during handling and processing of filter media 10. The stabilizing layer 23 is preferably made from a non-woven having an area weight of about 2 to 10, preferably 3 to 5 g/m² and can be attached to the depth filtration media layer 18 thermally, mechanically or by means of an adhesive.

Depth filtration media layer 18 of composite filter media 3 is preferably a non-woven fibrous polymeric web, such as a spun bond or preferably a melt blown web, consisting of polypropylene or polyethylene, non-woven polyester fabric, fiberglass, microfiberglass, cellulose and polytetrafluoroethylene.

Melt blown webs are produced by entraining melt spun fibers with convergent streams of heated air to produce extremely fine filaments. Melt blown processing forms continuous sub-denier fibers, with relatively small diameter fibers that are typically less than 10 microns.

The melt blown polymer fiber web layer(s) can be made from a variety of polymeric materials, including polypropylene, polyester, polyamide, polyvinylchloride, polymethylmethacrylate, and polyethylene. Polypropylene is among the more preferred polymeric materials. Typically, the polymer fibers that form the web have a diameter in the range of about 0.5 µm to about 10 µm. Preferably, the fiber diameter is about 1 µm to about 5 µm.

The thickness of the depth filtration media layers 18 is not critical. If the depth filtration media is a melt blown web, for example, the thickness may be from about 0.25 mm to about 3 mm. Greater thickness results in higher dust capacity. However, excessively thick depth filtration media layers may limit the total number of layers that can be used in the composite filter media.

The selection of the basis weight of the depth filtration media is also within the capability of those of skill in the art. The weight of a melt blown polymer fiber web may, for example, be in the range of about 1 g/m² to about 100 g/m², preferably the basis weight of the melt blown fiber web is about 10 g/m² to about 50 g/m².

At least one depth filtration media layer is formed as an electret filter media comprising a highly efficient layer having an electrostatic charge. Electric charge is imparted to melt blown fibrous webs to improve their filtration performance using a variety of known techniques.

For example, a suitable web is conveniently cold charged by sequentially subjecting the web to a series of electric fields, such that adjacent electric fields have substantially opposite polarities with respect to each other, in the manner taught in US-Patent No. 5,401,446, to Tsai et al. As described therein, one side of the web is initially subjected to a positive charge while the other side of the web is initially subjected to a negative charge. Then the first side of the web is subjected to a negative charge and the other side of the web is subjected to a positive charge. However, electret filter materials may also be made by a variety of other known techniques.

The depth filtration media layer 18 may also contain additives to enhance filtration performance and may also have low levels of extractable hydrocarbons to improve performance. The fibers may contain certain melt processable fluorocarbons, for example, fluorochemical oxazolidinones and piperazines and compounds of oligomers that contain perfluorinated moieties. The use of such additives can be particularly beneficial to the performance of an electrically charged web filter. Further, the prefilter could be surface-treated with suitable chemical containing fluorated polymers to provide a certain water repellency.

Downstream of depth filtration media layer 18 is disposed microporous polymeric membrane filtration layer 20. Microporous polymeric membrane 20 is intended to capture particles that pass through the depth filtration layers. Microporous polymeric membranes have demonstrated dependability and reliability in removing particles and organisms from fluid streams. Membranes are usually characterized by their polymeric composition, air permeability, water intrusion pressure and filtration efficiencies.

A variety of microporous polymeric membranes can be used as the membrane filtration layer, depending on the requirements of the application. The membrane filtration layer may be constructed from the following exemplary materials: nitrocellulose, triacetyl cellulose, polymide, polycarbonate, polyethylene, polypropylene, polytetrafluorethylene, polysulfone, polyvinylchloride, polyvinylidene fluorid, acrylate copolymer.

The membrane filtration layer is preferably constructed from a hydrophobic material that is capable of preventing the passage of liquids. The membrane filtration layer must be able to withstand the applied differential pressure across the filter media without any liquid passing through it. The preferred membrane has a water intrusion pressure of at least 0.2 bar, preferably more than 0.5 bar, and an average air permeability of about 7 Frazier to about 100 Frazier, and more preferably an average air permeability of at least about 30 Frazier, most preferably of at least about 60 Frazier.

Preferably, the membrane filtration layer is a microporous fluoropolymer, such as ePTFE, fluorinated ethylenepropylene (FEP), perfluoroalkoxy polymer (PFA), polypropylene (PU), polyethylene (PE) or ultra high molecular weight polyethylene (uhmwPE).

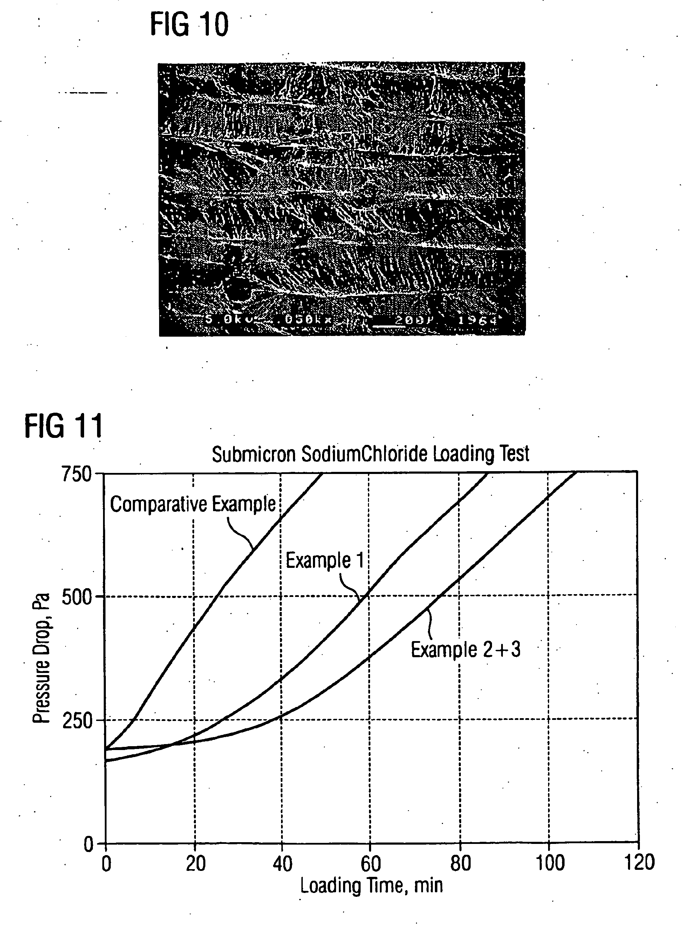

Most preferably, the membrane filtration layer comprises ePTFE. Suitable ePTFE membranes are described in US 5,814,405. The membranes described therein have good filtration efficiency, high air flow and burst strength. Figure 10 depicts an SEM image taken from the aforementioned US patent and is introduced in this application to give an example of the microstructure of the ePTFE membranes described therein. As can be seen, the microstructure of the membrane consists of a series of nodes interconnected by fibrils, wherein the nodes are generally arranged in parallel, highly elongated and have an aspect ratio of 25:1 or greater. It is believed that the long nodes of the microstructure help prevent any splitting of the membrane during the filter pleating process, thereby avoiding the danger of pin hole formation.

Membrane filtration layer 20 may optionally contain a filler material to improve certain properties of the filter. Suitable fillers, such as carbon black, or other conductive filler, catalytic particulate, fumed silica, colloidal silica or adsorbent materials, such as activated carbon or ceramic fillers, such as activated alumina and TiO₂, and methods preparing filled membranes useful in the present invention are fully described in US 5,814,405.

Support layer 22 is provided to stabilize filtration layer 20. Preferred supporting material must therefore be rigid enough to support the membrane and depth filtration layers, but soft and supple enough to avoid damaging the membrane. The support layer 22 may comprise non-woven or woven fabrics. Other examples of suitable support layer materials may include, but are not limited to, woven and non-woven polyester, polypropylene, polyethylene, fibreglass, microfiberglass, and polytetrafluorethylene. The fiber thickness of the support layer 22 is preferably in the range of 10 µm to 30 µm, more preferably not less than 15 µm. In a pleated orientation, the material should provide airflow channels in the pleats apart (i.e., preventing the pleats from collapsing). Materials such as spunbonded non-wovens are particularly suitable for use in this application.

Support layer 22 may be positioned upstream or downstream of the membrane filter layer 20. Support material 22 may be laminated to the membrane filtration layer to form a base layer. In this aspect, the base layer advantageously provides both support to the overlaying melt blown media layer and acts as the final filtration surface.

### TEST METHODS

### Permeability

Air permeability can be determined according to a Frazier number test method. In this method, air permeability is measured by clamping a test sample in a gasketed-flanged fixture, which provides a circular section of approximately 2.75 inches in diameter and 6 square inches in area for air flow measurement. The upstream side of the sample fixture is connected to a flow meter in line with a source of dry compressed air. The downstream side of the sample fixture is open to the atmosphere. Testing is accomplished by applying an air pressure of 0.5 inches of water to the upstream side of the sample and recording the flow rate of the air passing through the in-line flowmeter (a ball-float rotameter). The sample is conditioned at 21°C and 65 % relative humidity for at least 4 hours prior to testing. Results are reported in terms of Frazier Number which has units of cubic feet/minute/square foot of sample at 0.5 inches of water pressure.

### Dust Capacity:

Dust capacity may be determined according to the following method. A 3 % aqueous sodium chloride solution is atomized using a constant output atomizer (TSI Model 3096; Shoreview, MN). The particles are dried by heating at 80°C and then diluted with clean dry air. The particle size distribution is measured by an aerodynamic particle sizer (e.g., TSI Model 3320; Shoreview, MN). The geometric mean particle diameter and standard deviation are determined.

The filter test sample, 44.4 mm in diameter, is weighed prior to testing and is placed inside a filter holder. The face velocity is set to 5.3 cm/s. The pressure drop across the filter is monitored continuously by a pressure transducer (e.g., Heise Model PM10; Stratford, CT). The filter is loaded with the sodium chloride aerosol until the final pressure drop across the filter media reaches 750 Pa. The test sample is weighed again after the test to determine the mass loading. The dust loading capacity is the difference between the final and initial mass of the test sample.

### Filtration Efficiency:

The particle collection efficiency is measured by an automated efficiency tester (e.g., Model 8160, available from TSI, Inc., St. Paul, Minnesota). The test is performed at ambient room temperature (70°F) and relative humidity conditions (40 %). A dioctyl-phthalate (DOP) solution is atomized to generate an aerosol containing particles from 0.03 to 0.5 microns in diameter. The filter sample is challenged with the aerosol at air flow velocity of 5.3 cm/s. Two condensation nucleus particle counters measure the particle concentrations upstream and downstream of the test sample simultaneously. The particle condition efficiency is reported as the percentage of upstream challenge particles collected by the filter.

### COMPARISON OF CHARGED AND DISCHARGED MELT BLOWNS

The different efficiency of charged and discharged melt blowns is shown in table 1 below in respect of three examples A, B and C.

**Table 1**

| **Filter** | **Permeability, frazier** | **Loading Capacity, mg** | **Dust Capacity, g/m²** | **Improvement** |
|---|---|---|---|---|
| Example A ePTFE | 7.6 | 8.8 | 6.4 | - |
| Example B ePTFE+MB charged | 4.9 | 12.6 | 9.1 | 43% |
| Example C ePTFE+MB neutral | 5.1 | 4.4 | 3.2 | -50% |

Example A relates to an ePTFE membrane laminate comprising a ePTFE membrane with a 203 g/m² polyester spunbond backer as a support layer. The membrane had a permeability of about 7.6 Frazier and exhibited a dust capacity of 6.4 g/m² under certain test conditions.

Example B relates to an inventive composite filter media with a 30 g/m² polypropylene melt blown being ultrasonically bonded to the ePTFE membrane laminate of example A. The melt blown used in this example is available from Hollingsworth and Vose company, based in East Walpole, MA. as part number TR1462A. Ultrasonic bonding was made over the whole surface of the filter with small weld points of about 0.8 mm in size, there being approximately 55500 points/m³. The permeability of the composite filter media was about 4.9 Frazier and the filter media exhibited a dust capacity of 9.1 g/m³ under the same test conditions, this being an improvement of 43 %.

While the composite filter media in example B was electrostatically charged according to the present invention, example C relates to the same composite filter media, however, discharged by dipping it in isopropyl-alcohol or isopropanol to neutralize the electrostatic charge and subsequent drying. While the permeability did not change much, as could be expected, example C exhibited a lower dust capacity than example B, i.e. a dust capacity of 3.2 g/m³ only. Surprisingly, the uncharged composite filter media resulted in a dust capacity that was even lower than that of the ePTFE laminate alone.

### COMPARATIVE EXAMPLE

A microporous ePTFE membrane laminate, available from W.L. Gore & Associates, Inc. (Newark, DE), illustrates the loading capacity of membrane filter. The ePTFE membrane has air permeability in the range of 18 to 29 Frazier, ball burst strength greater than 0.2 bar, weight about 5 g/m². The ePTFE membrane is bonded to a polyester spunbond support material (available from Toray, Japan) with basis weight of 270 g/m², air permeability between 28 to 32 Frazier, and mullen burst greater than 14 bar. The membrane is bonded to the support material at temperature between 180°C and 350°C, and pressure between 0.1 to 7 bar. The resulting ePTFE laminate has air permeability between 5 to 8 Frazier. The filter is loaded with sodium chloride aerosol in accordance with the test procedure described previously until pressure drop reaches 750 Pa. The dust loading curve for the laminate is shown in figure 6. The total dust loading capacity is 14 mg.

### EXAMPLE 1

A layer of 10 g/m² melt blown media (DelPore 6001-10P, available from DelStar, Inc.; Middletown, DE) are placed upstream of the ePTFE membrane laminate of comparative example 1 to form a composite media. The melt blown media is made of 10 g/m² polypropylene meltblown layer and 10 g/m² polyester spun bond scrim. The polypropylene fibers have diameters of from 1 to 5 µm. The mean pore size is about 15 µm and the media thickness is about 0.2 mm. The air permeability of the depth filtration layer is about 130 Frazier. The media is electrically charged to enhance particle collection efficiency. The filter is loaded with sodium chloride aerosol in accordance with the test procedure described previously until pressure drop reaches 750 Pa. The loading curve is depicted in figure 6.

### EXAMPLE 2

A depth filtration media layer of 30 g/m² melt blown media (DelPore 6001-30P, available from DelStar, Inc.; Middletown, DE) is positioned upstream of the microporous ePTFE laminate of Comparative Example 1 to form a composite media. The melt blown media is made of 30 g/m² polypropylene fibers layer and 10 g/m² polyester spun bond scrim. The polypropylene fibers have diameters from 1 to 5 µm. The mean pore size is about 15 µm and have the media thickness is about 0.56 mm. The air permeability of the meltblown is about 37 Frazier. The media is electrically charged to enhance particle collection efficiency. Two layers of this meltblown media are placed upstream of the microporous ePTFE laminate. The filter is loaded with sodium chloride aerosol as described previously until pressure drop reaches 750 Pa. The results are depicted in figure 6.

### EXAMPLE 3

A depth filtration media layer of 30 g/m² melt blown polypropylene (DelPore 6001-30P, available from DelStar, Inc.; Middletown, DE, USA) is positioned upstream of the microporous ePTFE laminate of Comparative Example to form a composite media. The melt blown media is made of 30 g/m² polypropylene fibers layer and 10 g/m² polyester spun bond scrim. The scrim supports the soft melt blown media. The polypropylene fibers have diameters from 1 to 5 µm. The mean pore size is about 15 µm and the media thickness is about 0.56 µm. The air permeability of the melt blown is about 37 Frazier. The media is electrically charged to enhance particle collection efficiency. One layer of this melt blown media is placed upstream of and connected to the microporous ePTFE laminate to form a composite filter media wherein the scrim forms the outer upstream side. The filter is loaded with sodium chloride aerosol as described previously until pressure drop reaches 760 Pa.

The composite media is used to form a cartridge filter as shown in Fig. 3. The cartridge filter comprises the pleated composite media material, which is arranged in a circle, so that at least one of the side edges are sealed by corresponding closure caps. The cartridge filter comprises a high of 70 cm and a diameter of 35 cm. The pleated composite media material of one filter has a filtration area of 12.6 m². The air flow rate of 1000 m³/h is reached at a pressure drop of approximately 180 Pa if the filter is new. The inside 15 of the media material circle has a metal grid.

The filtration efficiency of the filter is shown in table 2 below. Table 2 shows the efficiency between a ePTFE membrane (as described in example 1), a layer of 30 g/m² melt blown and a filter composite according to example 3.

All three samples were tested with an approach velocity of 1 cm/s and 5.3 cm/s. The composite according Example 3 has the highest filtration efficiency.

**Table 2**

| **Efficiency @ 1 cm/s** | | | **Efficiency @ 5.3 cm/s** | | | |
|---|---|---|---|---|---|---|
| **Particle Size, µm** | **ePTFE** | **30 g/m² melt blown** | **Composite** | **ePTFE** | **30 g/m² melt blown** | **Composite** |
| 0.03 | 99.786 | 99.218 | **99.977** | 97.141 | 83.185 | **99.226** |
| 0.05 | 99.652 | 95.120 | **99.961** | 95.997 | 81.523 | **98.898** |
| 0.07 | 99.490 | 94.809 | **99.946** | 95.082 | 80.417 | **98.703** |
| **0.1** | 99.274 | 95.721 | **99.939** | 94.868 | 81.093 | **98.867** |
| 0.15 | 99.189 | 96.847 | **99.954** | 95.551 | 81.643 | **99.145** |
| 0.2 | 99.265 | 97.655 | **99.974** | 96.659 | 82.349 | **99.440** |
| 0.3 | 99.570 | 98.587 | **99.993** | 98.360 | 85.424 | **99.779** |

## Claims

1. Fan cooling unit (100) for cooling electronic components (7), comprising a casing (8) to take the electronic components (7), at least one air inlet opening (11) and at least one air outlet opening (12) in the casing (8), at least one fan (6) to produce a flow of air from the air inlet opening (11) through the casing (8) to the air outlet opening (12), and at least one protective covering (1) to entirely cover at least the air inlet opening (11) for removal of particles from an air stream entering the casing (8), said protective covering comprising a composite filter media (3) and a frame (2) into which the composite filter media (3) is mounted so as to create an air-tight fit between the filter media (3) and the frame (2), wherein the filter media (3) is of multi-layer structure comprising
- a membrane filtration layer (20) comprising a porous polymeric membrane, and
- at least one depth filtration media layer (18) comprising fibers and disposed on an upstream side of the membrane filtration layer (20) relative to a direction of gas flow through the filter.

2. Fan cooling unit according to claim 1, wherein the membrane filtration layer (20) comprises porous polytetrafluoroethylene (ePTFE).

3. Fan cooling unit according to any of claims 1 or 2, wherein a support layer (22) is disposed on the upstream or downstream side of and adjacent to the membrane filtration layer (20).

4. Fan cooling unit according to claim 3, wherein the support layer (22) is laminated to the membrane filtration layer (20).

5. Fan cooling unit according to any of claims 1 to 4, wherein the at least one depth filtration media layer (18) comprises a non-woven fibrous polymeric web.

6. Fan cooling unit according to claim 5, wherein the non-woven fibrous polymeric web is a melt blown web.

7. Fan cooling unit according to any of claims 1 to 6, wherein the membrane filtration layer has a permeability of at least 7 Frazier, more preferably of at least about 30 Frazier, most preferably of 60 Frazier or greater.

8. Fan cooling unit according to any of claims 1 to 7, wherein each of the at least one depth filtration media layer (18) has a permeability of at least about 30 Frazier, more preferably of at least about 100 Frazier.

9. Fan cooling unit according to any of claims 1 to 8, comprising a stabilizing layer (23) adjacent to and on the upstream side of the at least one depth filtration media layer (18) to prevent disarrangement of the fibers in the at least one depth filtration media layer (18).

10. Fan cooling unit according to any of claims 1 to 9, wherein the composite filter media (3) has a particle filtration efficiency of at least 90% for 0.3 micron sized particles at a face velocity of 10 cm/s or below.

11. Fan cooling unit according to any of claims 1 to 10, wherein the membrane filtration layer (20) and the at least one depth filtration media layer (18) are pleated.

12. Fan cooling unit according to claim 11, wherein the filter media (3) is shaped as a pleated panel.

13. Fan cooling unit according to claim 12, wherein two edges of the panel are joined to form a cylindrical filter media.

14. Fan cooling unit according to any of claims 1 to 13, wherein the membrane filtration layer (20) is a microporous polytetrafluoroethylene (ePTFE) membrane having an internal microstructure consisting essentially of a series of nodes interconnected by fibrils, wherein the nodes are generally arranged in parallel, highly elongated and have an aspect ratio of 25:1 or greater.

15. Fan cooling unit according to claim 14, wherein the nodes have an aspect ratio of 150:1 or greater.

16. Fan cooling unit according to any of claims 14 or 15, wherein the polytetrafluoroethylene (PTFE) is a blend of a FTFE-homopolymer and a modified PTFE-polymer.

17. Fan cooling unit according to any of claims 14 to 16, wherein the membrane filtration layer has a mean flow pore size greater than 1.5 *µ*m.

18. Fan cooling unit according to claim 17, wherein the mean flow pore size is about 3 *µ*m.

19. Fan cooling unit according to any of claims 1 to 18, wherein the protective covering (1) is mounted in the air inlet opening (11).

20. Fan cooling unit according to any of claims 1 to 19, wherein the fan (6) is fitted in the casing (8) on a casing wall (13) situated opposite the air inlet opening (11).

21. Fan cooling unit according to any of claims 1 to 20, wherein the casing (8) is an all weather casing for use at a location exposed to the effects of all weather conditions.

22. Fan cooling unit according to any of claims 1 to 21, wherein a louvred panel (5) is fitted on the outsize in front of the protective covering (1).

23. Fan cooling unit according to any of claims 1 to 22, wherein the fibers of the depth filtration media layer (18) have an electrostatic charge.

24. Use of a fan cooling unit according to any of claims 1 to 23 for cooling electronic components (7).

25. Use according to claim 24 for an air-cooled telecommunications base station.

## Patentansprüche

1. Gebläsekühleinheit (100) zum Kühlen von elektronischen Komponenten (7), umfassend ein Gehäuse (8), um die elektronischen Komponenten (7) aufzunehmen, wenigstens eine Lufteinlassöffnung (11) und wenigstens eine Luftauslassöffnung (12) in dem Gehäuse (8), wenigstens ein Gebläse (6), um eine Luftströmung von der Lufteinlassöffnung (11) durch das Gehäuse (8) zu der Luftauslassöffnung (12) zu erzeugen, und wenigstens eine Schutzabdeckung (1), um wenigstens die Lufteinlassöffnung (11) zur Entfernung von Partikeln aus einem Luftstrom, welcher in das Gehäuse (8) eindringt, vollständig zu bedecken, wobei die Schutzabdeckung ein Verbundfiltermedium (3) und einen Rahmen (2) umfasst, in welchem das Verbundfiltermedium (3) angebracht ist, um eine luftdichte Passung zwischen dem Filtermedium (3) und dem Rahmen (2) zu schaffen, wobei das Filtermedium (3) eine mehrschichtige Struktur ist, welche umfasst
- eine Membranfiltrationsschicht (20), umfassend eine poröse Polymermembran und
- wenigstens eine Tiefenfiltrationsmediumsschicht (18), welche Fasern umfasst und auf einer im Verhältnis zu einer Richtung einer Gasströmung durch den Filter vorgeschalteten Seite der Membranfiltrationsschicht (20) angeordnet ist.

2. Gebläsekühleinheit nach Anspruch 1, wobei die Membranfiltrationsschicht (20) poröses Polytetrafluorethylen (ePTFE) umfasst.

3. Gebläsekühleinheit nach einem der Ansprüche 1 oder 2, wobei eine Stützschicht (22) auf der vorgeschalteten oder nachgeschalteten Seite und benachbart zu der Membranfiltrationsschicht (20) angeordnet ist.

4. Gebläsekühleinheit nach Anspruch 3, wobei die Stützschicht (22) auf die Membranfiltrationsschicht (20) laminiert ist.

5. Gebläsekühleinheit nach einem der Ansprüche 1 bis 4, wobei wenigstens eine Tiefenfiltrationsmediumschicht (18) ein vliesartiges, fasriges Polymergewebe umfasst.

6. Gebläsekühleinheit nach Anspruch 5, wobei das vliesartige, fasrige Polymergewebe ein Meltblown-Gewebe ist.

7. Gebläsekühleinheit nach einem der Ansprüche 1 bis 6, wobei die Membranfiltrationsschicht eine Permeabilität von wenigstens 7 Frazier, besonders bevorzugt von wenigstens ungefähr 30 Frazier, am meisten bevorzugt von 60 Frazier oder größer aufweist.

8. Gebläsekühleinheit nach einem der Ansprüche 1 bis 7, wobei jede der wenigstens einen Tiefenfiltrationsmediumsschicht (18) eine Permeabilität von wenigstens 30 Frazier, besonders bevorzugt von wenigstens ungefähr 100 Frazier aufweist.

9. Gebläsekühleinheit nach einem der Ansprüche 1 bis 8, umfassend eine stabilisierende Schicht (23) benachbart zu und auf der vorgeschalteten Seite der wenigstens einen Tiefenfiltrationsmediumsschicht (18), um ein Durcheinandergeraten der Fasern in der wenigstens einen Tiefenfiltrationsmediumsschicht (18) zu verhindern.

10. Gebläsekühleinheit nach einem der Ansprüche 1 bis 9, wobei das Verbundfiltermedium (3) eine Partikelfiltrationseffizienz von wenigstens 90 % für Partikel mit einer Größe von 0,3 µm bei einer Anströmgeschwindigkeit von 10 cm/s oder weniger aufweist.

11. Gebläsekühleinheit nach einem der Ansprüche 1 bis 10, wobei die Membranfiltrationsschicht (20) und die wenigstens eine Tiefenfiltrationsmediumsschicht (18) gefaltet sind.

12. Gebläsekühleinheit nach Anspruch 11, wobei das Filtermedium (3) als eine gefaltete Platte geformt ist.

13. Gebläsekühleinheit nach Anspruch 12, wobei zwei Kanten der Platte verbunden sind, um ein zylindrisches Filtermedium zu bilden.

14. Gebläsekühleinheit nach einem der Ansprüche 1 bis 13, wobei die Membranfiltrationsschicht (20) eine mikroporöse Polytetrafluorethylen (ePTFE) Membran ist, welche eine interne Mikrostruktur aufweist, welche im Wesentlichen aus einer Reihe von durch Fibrillen miteinander verbundenen Knoten besteht, wobei die Knoten im Allgemeinen parallel angeordnet sind, hochgradig gestreckt sind und ein Längen-Dicken-Verhältnis von 25:1 oder größer haben.

15. Gebläsekühleinheit nach Anspruch 14, wobei die Knoten ein Längen-Dicken-Verhältnis von 150:1 oder größer haben.

16. Gebläsekühleinheit nach einem der Ansprüche 14 oder 15, wobei das Polytetrafluorethylen (PTFE) ein Gemisch aus einem PTFE-Homopolymer und einem modifizierten PTFE-Polymer ist.

17. Gebläsekühleinheit nach einem der Ansprüche 14 bis 16, wobei die Membranfiltrationsschicht eine mittlere Strömungsporengröße größer als 1,5 µm aufweist.

18. Gebläsekühleinheit nach Anspruch 17, wobei die mittlere Strömungsporengröße ungefähr 3 µm ist.

19. Gebläsekühleinheit nach einem der Ansprüche 1 bis 18, wobei die Schutzabdeckung (1) in der Lufteinlassöffnung (11) angebracht ist.

20. Gebläsekühleinheit nach einem der Ansprüche 1 bis 19, wobei das Gebläse (6) in dem Gehäuse (8) an einer Gehäusewand (13), welche sich gegenüber der Lufteinlassöffnung (11) befindet, angepasst ist.

21. Gebläsekühleinheit nach einem der Ansprüche 1 bis 20, wobei das Gehäuse (8) ein Allwettergehäuse zur Verwendung an einem den Effekten aller Wetterbedingungen ausgesetzten Ort ist.

22. Gebläsekühleinheit nach einem der Ansprüche 1 bis 21, wobei eine Lamellenplatte (5) auf der Außenseite vor der Schutzabdeckung (1) angepasst ist.

23. Gebläsekühleinheit nach einem der Ansprüche 1 bis 22, wobei die Fasern der Tiefenfiltrationsmediumsschicht (18) eine elektrostatische Ladung aufweisen.

24. Verwendung einer Gebläsekühleinheit nach einem der Ansprüche 1 bis 23 zum Kühlen von elektronischen Komponenten (7).

25. Verwendung nach Anspruch 24 für eine luftgekühlte Telekommunikationsbasisstation.

## Revendications

1. Unité de refroidissement par ventilateur (100) destinée à refroidir des composants électroniques (7), comprenant un carter (8) pour recevoir les composants électroniques (7), au moins une ouverture d'amission d'air (11), et au moins une ouverture de sortie d'air (12) dans le carter (8), au moins un ventilateur (6) pour produire un écoulement d'air allant de l'ouverture d'admission d'air (11) à travers le carter (8) jusqu'à l'ouverture de sortie d'air (12), et au moins un couvercle de protection (1) pour recouvrir entièrement au moins l'ouverture d'admission d'air (11) en vue de l'élimination de particules dans un flux d'air entrant dans le carter (8), ledit couvercle de protection comprenant une couche filtrante composite (3) et un cadre (2) sur lequel la couche filtrante composite (3) est montée de manière à créer un ajustage étanche à l'air entre la couche filtrante (3) et le cadre (2), dans laquelle la couche filtrante (3) est une structure multicouche comprenant :
- une couche filtrante de filtration à membrane (20) comprenant une membrane polymère poreuse, et
- au moins une couche de filtration en profondeur (18) comprenant des fibres et disposée sur un côté amont de la couche de filtration à membrane (20) par rapport à une direction d'écoulement des gaz à travers le filtre.

2. Unité de refroidissement par ventilateur selon la revendication 1, dans laquelle la couche de filtration à membrane (20) comprend du polytétrafluoroéthylène poreux (ePTFE).

3. Unité de refroidissement par ventilateur selon l'une quelconque des revendications 1 ou 2, dans laquelle la couche de support (22) est disposée sur le côté amont ou aval de la couche de filtration à membrane (20), et de manière adjacente à celle-ci.

4. Unité de refroidissement par ventilateur selon la revendication 3, dans laquelle la couche de support (22) est laminée sur la couche de filtration à membrane (20).

5. Unité de refroidissement par ventilateur selon l'une quelconque des revendications 1 à 4, dans laquelle la au moins une couche filtrante de filtration en profondeur (18) comprend une toile polymère fibreuse non tissée.

6. Unité de refroidissement par ventilateur selon la revendication 5, dans laquelle la toile polymère fibreuse non tissée est une toile obtenue par fusion-soufflage.

7. Unité de refroidissement par ventilateur selon l'une quelconque des revendications 1 à 6, dans laquelle la couche de filtration à membrane présente une perméabilité d'au moins 7 Frazier, plus préférablement d'au moins environ 30 Frazier, et le plus préférablement de 60 Frazier, voire davantage.

8. Unité de refroidissement par ventilateur selon l'une quelconque des revendications 1 à 7, dans laquelle chacune de la au moins une couche filtrante de filtration en profondeur (18) présente une perméabilité d'au moins environ 30 Frazier, et plus préférablement d'au moins environ 100 Frazier.

9. Unité de refroidissement par ventilateur selon l'une quelconque des revendications 1 à 8, comprenant une couche de stabilisation (23) adjacente à la au moins une couche filtrante de filtration en profondeur (18), et sur le côté amont de celle-ci, afin d'empêcher toute désorganisation des fibres dans la au moins une couche filtrante de filtration en profondeur (18).

10. Unité de refroidissement par ventilateur selon l'une quelconque des revendications 1 à 9, dans laquelle la couche filtrante composite (3) présente une efficacité de filtration des particules d'au moins 90% pour des particules d'une taille de 0,3 micron pour une vitesse à la face de 10 cm/s ou inférieure.

11. Unité de refroidissement par ventilateur selon l'une quelconque des revendications 1 à 10, dans laquelle la couche de filtration à membrane (20) et la au moins une couche filtrante de filtration en profondeur (18) sont plissées.

12. Unité de refroidissement par ventilateur selon la revendication 11, dans laquelle la couche filtrante (3) présente la forme d'un panneau plissé.

13. Unité de refroidissement par ventilateur selon la revendication 13, dans laquelle deux bords du panneau sont joints pour former une couche filtrante cylindrique.

14. Unité de refroidissement par ventilateur selon l'une quelconque des revendications 1 à 13, dans laquelle la couche de filtration à membrane (20) est une membrane en polytétrafluoroéthylène microporeux (ePTFE) présentant une microstructure interne consistant essentiellement en une série de noeuds interconnectés par des fibrilles, dans laquelle les noeuds sont généralement agencés de manière parallèle et très allongée et présentent un rapport de longueur de 25:1, voire davantage.

15. Unité de refroidissement par ventilateur selon la revendication 14, dans laquelle les noeuds présentent un rapport de longueur de 150:1, voire davantage.

16. Unité de refroidissement par ventilateur selon l'une quelconque des revendications 14 ou 15, dans laquelle le polytétrafluoroéthylène (PTFE) est un mélange d'un homopolymère PTFE et d'un polymère PTFE modifié.

17. Unité de refroidissement par ventilateur selon l'une quelconque des revendications 14 à 16, dans laquelle la couche de filtration à membrane présente une taille de pore d'écoulement moyen supérieure à 1,5 µm.

18. Unité de refroidissement par ventilateur selon la revendication 17, dans laquelle la taille de pore d'écoulement moyen est d'environ 3 µm.

19. Unité de refroidissement par ventilateur selon l'une quelconque des revendications 1 à 18, dans laquelle le couvercle de protection (1) est monté dans l'ouverture d'admission d'air (11).

20. Unité de refroidissement par ventilateur selon l'une quelconque des revendications 1 à 19, dans laquelle le ventilateur (6) est installé dans le carter (8) sur une paroi de carter (13) située à l'opposé de l'ouverture d'admission d'air (11).

21. Unité de refroidissement par ventilateur selon l'une quelconque des revendications 1 à 20, dans laquelle le carter (8) est un carter à l'épreuve des intempéries destiné à une utilisation dans un endroit exposé aux effets de conditions de type intempéries.

22. Unité de refroidissement par ventilateur selon l'une quelconque des revendications 1 à 21, dans laquelle un panneau en chicane (5) est monté sur l'extérieur devant le couvercle de protection (1).

23. Unité de refroidissement par ventilateur selon l'une quelconque des revendications 1 à 22, dans laquelle les fibres de la couche filtrante de filtration en profondeur (18) présentent une charge électrostatique.

24. Utilisation d'unité de refroidissement par ventilateur selon l'une quelconque des revendications 1 à 23 destinée à refroidir des composants électroniques (7).

25. Utilisation selon la revendication 24 destinée à une station de base de télécommunications refroidie à l'air.
